# EUROPÄISCHE PATENTSCHRIFT

(11) **EP 0 500 551 B1**
(45) Veröffentlichungstag und Bekanntmachung des Hinweises auf die Patenterteilung: **20.04.1994**
(21) Anmeldenummer: 90914135.0
(22) Anmeldetag: 06.10.1990
(51) Int. Cl.: G01R 31/34

(54) **VERFAHREN ZUM PRÜFEN VON GENERATOREN**
PROCEDURE FOR TESTING GENERATORS
PROCEDE POUR LE CONTROLE DE GENERATRICES

(30) Priorität: 24.10.1989 DE 3935344
(43) Veröffentlichungstag der Anmeldung: 02.09.1992
(73) Patentinhaber: ROBERT BOSCH GMBH, 70442 Stuttgart (DE)
(72) Erfinder: SCHLIENZ, Ulrich, W-7580 Buehl-Neusatz (DE); SIEG, Raymond, D-7000 Stuttgart 50 (DE)
(86) Internationale Anmeldenummer: DE9000759
(87) Internationale Veröffentlichungsnummer: WO9106872

(56) Entgegenhaltungen:
- DD-A- 263 135
- GB-A- 2 122 749
- US-A- 3 629 704
- US-A- 4 156 845

## Beschreibung

### Stand der Technik

Die Erfindung betrifft ein Verfahren zum Prüfen von Generatoren und von als Generator betriebenen Motoren, die einen pulsförmigen Gleichstrom abgeben. Es ist allgemein bekannter Stand der Technik, die an einem Generator meßbare Spannung oder den Verlauf des abgegebenen Stroms auf einem Oszilloskop darzustellen. Diese Sichtprüfung gestattet das Erkennen von groben Fehlern wie beispielsweise Wicklungsschlüsse, Unterbrechungen oder defekte Gleichrichterdioden. Nicht sofort erkennbar sind kleinere Defekte wie beispielsweise eine sich langsam ändernde Durchlaßspannung eines Gleichrichters oder beispielsweise Winkelfehler, die bei der Generatorherstellung aufgetreten sind.

Der Erfindung liegt die Aufgabe zugrunde, ein Verfahren zum Prüfen von Generatoren und von als Generator betriebenen Motoren anzugeben, die einen pulsförmigen Gleichstrom abgeben, das eine objektive Messung aller denkbaren Fehler gestattet, die aus einem am Generator oder an einer am Generator angeschlossenen Last auftretenden Signal ableitbar sind.

### Vorteile der Erfindung

Das erfindungsgemäße Verfahren weist zunächst den Vorteil einer leichten Adaption auf. Es wird lediglich ein Anschluß am Generator oder an einer am Generator angeschlossenen Last benötigt. Sofern der Generator als Stromerzeuger in einem Kraftfahrzeug vorgesehen ist, wird ein Anschluß beispielsweise am Zigarettenanzünder möglich. Ein spezieller Sensor ist nicht erforderlich.

Ein weiterer Vorteil des erfindungsgemaßen Verfahrens ist es, daß verschiedene Typen von Generatoren prüfbar sind, die einen pulsförmigen Gleichstrom abgeben. Dazu zählen sowohl Gleichstromgeneratoren als auch Wechselstrom-/Drehstromgeneratoren, die Gleichrichter enthalten.

Neben Totalausfällen durch Kurzschlüsse zwischen Wicklungen oder Unterbrechungen sowie Defekte an Gleichrichtern sind auch kleinere Fehler wie beispielsweise Wicklungstoleranzen, Gleichrichtertoleranzen oder Winkeltoleranzen feststellbar, die insbesondere in der Generatorenfertigung bei der Qualitätssicherung zu berücksichtigen sind.

Neben Generatoren sind auch Motoren prüfbar, wenn sie als Generator betrieben werden und einen pulsförmigen Gleichstrom abgeben.

Vorteilhafte Weiterbildungen und Verbesserungen des erfindungsgemäßen Verfahrens sind in den Unteransprüchen angegeben.

Eine einfache Prüfung ist bereits durch das Auswerten von aufeinanderfolgenden Zeitabschnitten Ti des am Generator oder an der Last auftretenden Signals U möglich.

Eine präzise Aussage über den aufgetretenen Fehler sowie über den Ort des Fehlers ist durch eine Auswertung der Pulsdauern Ti möglich, bei der in einer signalverarbeitenden Anordnung jedes Ti dargestellt wird. Es ist auch möglich, auf einen aus vielen Pulsdauern Ti errechneten Mittelwert zu normieren und nur noch die Abweichung vom Mittelwert darzustellen. Da die Abweichungen vom Mittelwert nicht zufällig sind, ermittelt die signalverarbeitende Anordnung eine bestimmte Anzahl von Pulsdauern Ti, nach der sich das Fehlerbild wiederholt.

Besonders vorteilhaft ist die Vorgabe von Grenzwerten für die Pulsdauern Ti, mit der auch Totalausfälle erkenn- und lokalisierbar sind.

Eine vorteilhafte Ausgestaltung des erfindungsgemäßen Verfahrens betrifft die Signalaufbereitung des am Generator oder an der Last auftretenden Signals U, aus dem der Signalanteil mit Pulsdauern Ti des pulsierenden Stroms oder der pulsierenden Spannung ermittelt werden. Der Einsatz eines adaptiven Filters führt zu einer optimalen Befreiung von Störsignalen, die dem Signal U überlagert sind.

Eine vorteilhafte Weiterbildung des erfindungsgemäßen Verfahrens betrifft die Ermittlung der Pulsdauern Ti aus Kommutierungsschwingungen, die bei Wechselstrom-/Drehstromgeneratoren mit Gleichrichtern zwischen den Pulsdauern Ti kurzzeitig auftreten.

Die Prüfung des Generators kann auch bei veränderlicher Drehzahl vorgenommen werden, da im erfaßten Signal die Drehzahlinformation enthalten ist.

Das erfindungsgemäße Verfahren ist besonders geeignet zur Prüfung von Generatoren, die als Stromerzeuger von einer Brennkraftmaschine angetrieben werden, insbesondere eignet es sich zum Prüfen von im Kraftfahrzeug eingebauten, von einer Brennkraftmaschine angetriebenen Generatoren, die mit nur einem Anschluß an das Bordnetz detailliert überprüfbar sind.

Vorteilhafte Weiterbildungen und Verbesserungen des erfindungsgemäßen Verfahrens ergeben sich aus der folgenden Beschreibung und anhand der Zeichnung.

### Zeichnung

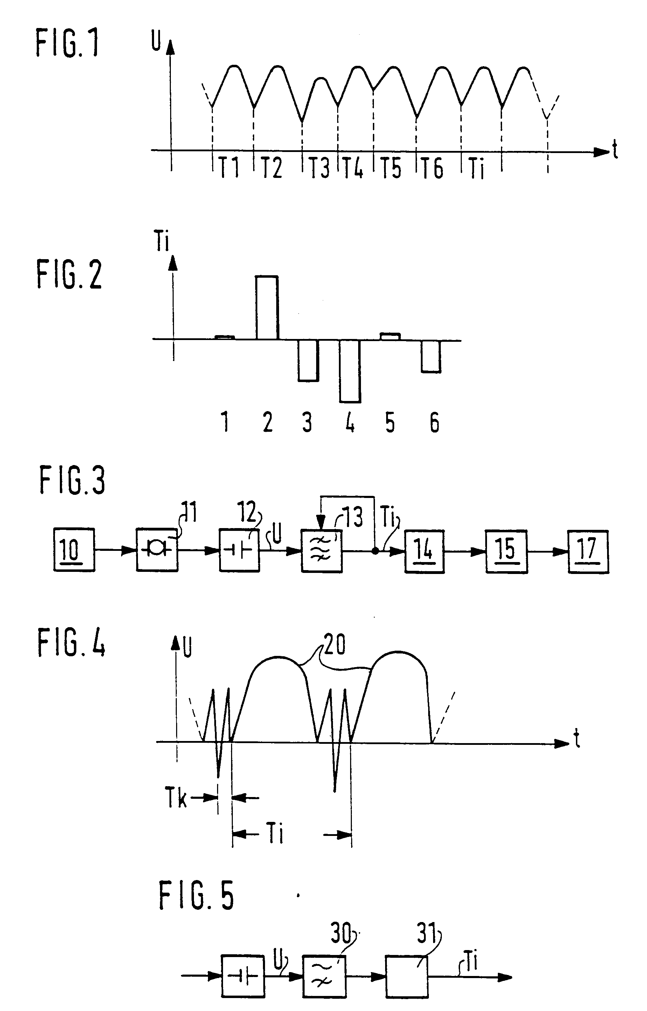

Figur 1 zeigt einen Signalverlauf mit einem pulsierenden Signal U mit Pulsdauern Ti, Figur 2 zeigt eine Häufigkeitsverteilung von einer bestimmten Anzahl von Pulsdauern Ti bezogen auf einen Mittelwert, Figur 3 zeigt ein Blockschaltbild einer signalverarbeitenden Anordnung, Figur 4 zeigt den in Figur 1 gezeigten Signalverlauf mit höherer zeitlicher Auflösung und Figur 5 zeigt ein Blockschaltbild einer weiteren signalverarbeitenden Anordnung zum Ermitteln der Pulsdauern Ti.

Figur 1 zeigt ein Signal U, das an einem Generator oder an einer vom Generator mit elektrischer Energie versorgten Last auftritt. Das Signal U weist einen Signalanteil mit Pulsdauern Ti auf, die unterschiedlich lang sein können. Ebenso können sich Äbweichungen in der Amplitude zwischen den einzelnen Impulsen ergeben.

Figur 2 zeigt sechs aufeinanderfolgende Pulsdauern Ti in Säulendarstellung.

Figur 3 zeigt ein Blockschaltbild einer signalverarbeitenden Anordnung. Mit der Bezugszahl 10 ist eine Brennkraftmaschine bezeichnet, die wenigstens einen Generator 11 antreibt. Der Generator 11 gibt elektrische Energie an eine Last 12 ab, die beispielsweise dem Bordnetz eines Kraftfahrzeugs entspricht, sofern der Generator 11 in einem Kraftfahrzeug angeordnet ist. Das an der Last 12 auftretende Signal U wird einem Signalfilter 13 zugeführt, dessen Ausgangssignal sowohl einer Schwellwertstufe 14 als auch dem Filter 13 selbst zugeleitet wird. Am Ausgang des Filters 13 tritt der Signalanteil des Signals U mit den Pulsdauern Ti auf, aus dem die Schwellwertstufe 14 geeignete Signale, vorzugsweise Digitalsignale für die nach folgender Auswerteeinheit 15 bereitstellt. Die Auswerteeinheit 15 gibt ein Ausgangssignal an eine Ausgabe 17 ab.

Figur 4 zeigt einen zeitlich höher aufgelösten Abschnitt des in Figur 1 gezeigten Signals U. Zwischen den Pulsdauern Ti sind kurzzeitige Kommutierungsschwingungen 20 vorhanden, die eine Periodendauer Tk aufweisen.

Figur 5 zeigt eine signalverarbeitende Anordnung zur Ermittlung der Pulsdauern Ti. Das Signal U wird über ein Hochpaßfilter 30 einem Signalformer 31 zugeleitet, an dessen Ausgang ein Signal mit den Zeiten Ti auftritt.

Das erfindungsgemäße Verfahren zum Prüfen von Generatoren oder von als Generator betriebenen Motoren wird anhand dem in Figur 2 gezeigten Blockschaltbild in Verbindung mit dem in Figur 1 gezeigten Signal U näher erläutert:

Der Generator 11, der beispielsweise von der Brennkraftmaschine 10 oder von einem anderen Motor angetrieben wird, versorgt beispielsweise die Last 12 mit elektrischer Energie. Es ist nicht erforderlich, daß eine Last 12 vorhanden ist, da das Signal U sowohl am Generator 11 ohne Last als auch an der Last 12 auftritt. Das Signal U ist beispielsweise die am Generator oder die an der Last 12 auftretende Spannung. Das Signal U kann aber auch ein Maß für den durch die Last 12 fließenden, vom Generator 11 abgegebenen Strom sein.

Als Generator 11 können unterschiedliche Typen vorgesehen sein. Der Generator 11 kann als Gleichstromgenerator oder als Wechselstromgenerator ausgestaltet sein. Der Wechselstromgenerator kann eine oder mehrere Phasen aufweisen. Die einzelnen Phasen des Wechselstromgenerators sind beispielsweise mit Gleichrichtern derart zusammengeführt, daß eine pulsierende Gleichspannung auftritt. Dieser Generatortyp wird als Drehstromgenerator bezeichnet und wird vorzugsweise zur Versorgung eines Bordnetzes mit elektrischer Energie in einem Kraftfahrzeug verwendet. Wesentlich ist, daß die in Figur 1 gezeigten charakteristischen Pulsdauern Ti im Signal U auftreten. Die Pulsdauern Ti hängen bei Gleichstromgeneratoren von der Anzahl der getrennten Ankerwicklungen und bei Wechselstromgeneratoren von der Anzahl der vorgesehenen Phasen ab. Die Pulsdauern Ti ändern sich in Abhängigkeit von der Drehzahl und gegebenenfalls in Abhängigkeit vom Übersetzungsverhältnis zwischen der Brennkraftmaschine 10 und dem angetriebenen Generator 11. Der charakteristische Signalverlauf des Signals U mit den Pulsdauern Ti ist in Figur 1 beispielhaft für eine gleichstromversorgte Last 12 angegeben, wobei nur der verhaltnismäßig geringe Wechselspannungsanteil unter Weglassung des erheblich höheren Gleichspannungsanteils gezeigt ist.

Zur Prüfung des Generators 11 wird zunächst mit dem Filter 13, das als Bandpaßfilter ausgestaltet ist, der Signalanteil des Signals U mit den Pulsdauern Ti abgetrennt. Das Filter 13 trennt sowohl unerwünschte niederfrequente als auch hochfrequente Störsignale ab, wie sie beispielsweise von einem gegebenenfalls vorhandenen Generatorregler oder von sonstigen Schaltvorgängen der Last 12 verursacht werden.

In einer vorteilhaften Ausgestaltung ist das Filter 13 als ein adaptives Filter ausgebildet, wofür sich insbesondere eine Realisierung als Digitalfilter oder als Filter mit geschalteten Kapazitäten eignet. Das Digitalfilter weist den großen Vorteil einer vollständigen Realisierbarkeit in Software auf. Zur Beurteilung des dem Filter 13 zugeführten Signals U kann der Bandpaß beispielsweise über das gesamte Frequenzband abgestimmt und die Ausgangsamplitude des Filters durch Amplitudenmessung bewertet werden. Da die Störungen nur sporadisch auftreten, die quasiperiodischen Vorgänge mit den Zeiten Ti dagegen kontinuierlich vorliegen, ist auf diese Weise ein korrektes Setzen der Bandpaßparameter des digitalen Filters oder des Filters mit geschalteten Kapazitäten möglich.

Die Schwellwertstufe 14, die gegebenenfalls vorgesehen ist, bereitet das die Pulsdauern Ti enthaltende Signal formgerecht für die Weiterverarbeitung in der Auswerteeinheit 15 auf.

Die Auswerteeinheit 15 ermittelt in einer einfacheren Ausführung die Differenzen der aufeinanderfolgenden Pulsdauern Ti und T(i+1), und gibt das Ergebnis über die Ausgabe 17 aus. Bereits mit der Differenzmessung ist zumindest eine qualitative Aussage über den Generator 11 möglich. Die Auswerteeinheit 15 kann aus den Pulsdauern Ti anhand einer Vorgabe über eine nicht näher dargestellte Eingabeeinheit komplexere Auswerteverfahren durchführen und über die Ausgabe 17 anzeigen, wobei die Ausgabe 17 auch beispielsweise ein größeres Diagnosesystem sein kann.

Die Pulsdauern Ti sind ebenfalls einzeln auswertbar. In Figur 2 ist ein daraus resultierendes Säulendiagramm gezeigt, wobei willkürlich davon ausgegangen wurde, daß sich die Pulsdauern Ti ab i = 7 wiederholen. Die Summe der Pulsdauern T1 - T6 entspricht entweder gerade einer Umdrehung des Generators oder einer elektrischen Periode. Dem hier gewählten Beispiel mit i = 6 liegt beispielsweise ein dreiphasiger Drehstromgenerator zugrunde.

Als Ursachen für die Abweichungen aufeinanderfolgender Pulsdauern Ti können beispielsweise Wicklungstoleranzen, Gleichrichtertoleranzen (unterschiedliche Durchlaßspannungen von Gleichrichterdioden) oder beispielsweise Winkeltoleranzen von Polen sein. Derartige Fehler lassen sich aus Figur 2 durch arithmetische Operationen mit den einzelnen Säulenhöhen ermitteln. Unterschiedliche Fehler führen zu unterschiedlichen, aber stets typischen Säulendarstellungen. Plausibilitätskontrollen ermöglichen der Auswerteeinheit 15 auch die Ermittlung von größeren Defekten im Generator 11. Beispielsweise würde durch Ausfall eines Gleichrichters eine bestimmte Pulsdauer Ti nicht mehr auftreten. Die Auswerteeinheit würde dann das in Figur 2 gezeigte Balkendiagramm auf i = 5 beschränken, wobei ein Balken eine sehr große Abweichung nach oben oder unten vom Mittelwert Tm zeigen würde. Durch Vorgabe von Grenzwerten führt die Plausibilitätskontrolle zu der Feststellung des richtigen Fehlers.

In einer weiteren Ausgestaltung kann jedes Ti auf den aus vielen Vorgängen errechneten Mittelwert Tm normiert und nur noch die Abweichung vom Mittelwert weiterverfolgt werden.

Gemäß einer vorteilhaften Ausgestaltung des erfindungsgemäßen Verfahrens werden die Pulsdauern Ti aus den in Figur 4 gezeigten Kommutierungsschwingungen 20 ermittelt, die eine Periodendauer Tk aufweisen. Die Schwingungen 20 treten auf, wenn der Generator 11 als Wechselstrom-/Drehstromgenerator mit Gleichrichtern ausgestaltet ist.

Nach der Anordnung gemäß Figur 5 wird das Signal U dem Filter 30 zugeleitet, das im einfachsten Fall als Hochpaßfilter ausgebildet ist, dessen untere Grenzfrequenz auf die Frequenz der Kommutierungsschwingungen 20 abgestimmt ist. Das Ausgangssignal des Filters 30 führt zum Signalformer 31, der beispielsweise als monostabiles Kippglied ausgebildet ist, das die Möglichkeit einer Re-Triggerung vorsieht, damit die Schwingungspakete jeweils nur einen einzigen Impuls am Ausgang des Pulsformers 31 auslösen. Auch das gemäß der signalverarbeitenden Anordnung nach Figur 5 ermittelte Signal mit den Anteilen Ti kann einer Plausibilitätskontrolle unterzogen werden, wodurch sich die Störfestigkeit erhöht. Unbrauchbare oder falsche Impulse, die zu falschen Pulsdauern Ti führen würden, könnten beispielsweise entstehen von Schaltvorgängen eines gegebenenfalls vorhandenen Generatorreglers oder von anderen elektrischen Verbrauchern, die am Generator angeschlossen sind. Die weitere Verarbeitung des Signals mit den Pulsdauern Ti ist in der in Figur 2 gezeigten Anordnung wie bereits beschrieben vorgesehen.

Die in den Figuren 3 und 5 gezeigten signalverarbeitenden Anordnungen 13 - 17, 30, 31 können vollständig oder teilweise als Software in einem Rechner realisiert sein.

## Patentansprüche

1. Verfahren zum Prüfen von Generatoren (11) oder von als Generator betreibbaren Motoren, die einen pulsförmigen Gleichstrom abgeben, bei dem die Pulsdauern Ti des pulsierenden Stromes oder der pulsierenden Spannung aus einem am Generator (11) oder an einer Last (12) auftretenden Signal (U) ermittelt wird.

2. Verfahren nach Anspruch 1, bei dem die Zeitdifferenz von aufeinanderfolgenden Pulsdauern (Ti) ermittelt wird.

3. Verfahren nach Anspruch 1, mit einer Berechnung der mittleren Pulsdauer Tm aus den Pulsdauern (Ti) und einer auf den Mittelwert Tm bezogenen Auswertung der Pulsdauern (Ti).

4. Verfahren nach einem der Ansprüche 1 bis 3, mit einer Plausibilitätskontrolle der Pulsdauern (Ti) durch Vorgabe von wenigstens einem minimalen und wenigstens einem maximalen Grenzwert.

5. Verfahren nach einem der vorhergehenden Ansprüche, bei dem der Signalanteil mit Pulsdauern (Ti) mit einem adaptiven Filter (13) aus dem Signal (U) herausgefiltert wird.

6. Verfahren nach einem der Ansprüche 1 bis 4, mit einer signalverarbeitenden Anordnung (30, 31), die den Signalanteil mit den Pulsdauern (Ti) aus Kommutierungsschwingungen (20) des Signals (U) ermittelt.

7. Verfahren nach Anspruch 6, mit einer Plausibilitätskontrolle des von der weiteren signalverarbeitenden Anordnung (30, 31) abgegebenen Signals.

8. Verfahren nach einem der vorhergehenden Ansprüche, mit einer Drehzahlmeßvorrichtung, die ein der Drehzahl entsprechendes Signal an eine Auswerteeinheit (15) zur Korrektur der erfaßten Pulsdauern (Ti) abgibt.

9. Verfahren nach einem der vorhergehenden Ansprüche zur Verwendung bei einem von einer Brennkraftmaschine angetriebenen Generator (11).

10. Verfahren nach Anspruch 9, bei dem die Brennkraftmaschine in einem Kraftfahrzeug angeordnet ist.

## Claims

1. Method for testing generators (11) or motors which can be operated as generators, which output a pulsed direct current, in which the pulse durations Ti of the pulsating current or of the pulsating voltage is [sic] determined from a signal (U) occurring at the generator (11) or at a load (12).

2. Method according to Claim 1, in which the time difference of successive pulse durations (Ti) is determined.

3. Method according to Claim 1, having calculation of the mean pulse duration Tm from the pulse durations (Ti), and evaluation of the pulse durations (Ti) which is referred to the mean value Tm.

4. Method according to one of Claims 1 to 3, having plausibility control of the pulse durations (Ti) by stipulation of at least one minimum and at least one maximum limit value.

5. Method according to one of the preceding claims, in which the signal component with pulse durations (Ti) is filtered out of the signal (U) by means of an adaptive filter (13).

6. Method according to one of Claims 1 to 4, having a signal processing arrangement (30, 31) which determines the signal component with pulse durations (Ti) from commutation oscillations (20) of the signal (U).

7. Method according to Claim 6, having a plausibility control of the signal output by the further signal processing arrangement (30, 31).

8. Method according to one of the preceding claims, having a tachometer which outputs a signal corresponding to the speed to an evaluation unit (15) for the purpose of correcting the detected pulse durations (Ti).

9. Method according to one of the preceding claims for use in a generator (11) driven by an internal-combustion engine.

10. Method according to Claim 9, in which the internal-combustion engine is arranged in a motor vehicle.

## Revendications

1. Procédé de contrôle de génératrices (11) ou de moteurs fonctionnant en génératrices et fournissant un courant continu impulsionnel dont la durée (Ti) des impulsions du courant impulsionnel ou de la tension impulsionnelle se détermine à partir du signal (U) pris sur la génératrice (11) ou sur une charge (12) reliée à la génératrice.

2. Procédé selon la revendication 1, selon lequel on détermine la différence de temps entre les durées des impulsions (Ti) successives.

3. Procédé selon la revendication 1, avec calcul de la durée impulsionnelle moyenne (Tm) à partir des durées d'impulsions (Ti) et les exploitations des durées (Ti) rapportées à la valeur moyenne (Tm).

4. Procédé selon l'une des revendications 1 à 3, avec contrôle de probabilités de durées d'impulsions (Ti) en prédéterminant au moins une valeur limite minimale et au moins une valeur limite maximale.

5. Procédé selon l'une des revendications précédentes, selon lequel on sépare par filtrage la partie du signal contenant les durées d'impulsions (Ti) à l'aide d'un filtre adaptatif (13) en partant du signal (U).

6. Procédé selon l'une des revendications 1 à 4, avec un montage de traitement de signal (30, 31) qui détermine la partie de signal de durées impulsionnelles (Ti) à partir des oscillations de commutation (20) du signal (U).

7. Procédé selon la revendication 6, avec contrôle de probabilités du signal fourni par l'autre montage de traitement de signal (30, 31).

8. Procédé selon l'une des revendications précédentes, avec un dispositif de mesure de vitesse de rotation qui fournit un signal correspondant à la vitesse de rotation à une unité d'exploitation (15) pour corriger la durée impulsionnelle (Ti).

9. Procédé selon l'une des revendications précédentes, applicable à une génératrice (11) entraînée par un moteur thermique.

10. Procédé selon la revendication 9, selon lequel le moteur thermique équipe un véhicule automobile.
